# FASCICULE DE BREVET EUROPEEN

(11) **EP 1 959 481 B1**
(45) Date de publication et mention de la délivrance du brevet: **19.12.2012**
(21) Numéro de dépôt: 08101468.0
(22) Date de dépôt: 11.02.2008
(51) Int. Cl.: H01L 21/28

(54) **Procédé de réalisation de transistor**
Verfahren zur Herstellung eines Transistors
Method of manufacturing a transistor

(30) Priorité: 15.02.2007 FR 0753288
(43) Date de publication de la demande: 20.08.2008
(73) Titulaire: Commissariat à l'Énergie Atomique et aux Énergies Alternatives, 75015 Paris (FR)
(72) Inventeur: Clavelier, Laurent, 38700 Voiron (FR); Mayer, Frédéric, 38000 Grenoble (FR); Vinet, Maud, 38140 Rives (FR); Deleonibus, Simon, 38640 Claix (FR)
(74) Mandataire: Ilgart, Jean-Christophe

(56) Documents cités:
- WO-A-02/37183
- US-A- 5 918 128
- US-A1- 2005 272 259
- US-B1- 6 867 116

## Description

### DOMAINE TECHNIQUE ET ART ANTÉRIEUR

L'invention concerne un procédé de réalisation de transistors par exemple de type TFET (« Tunnel Field Effect Transistor » en anglais, ou transistor à effet de champ à effet tunnel), CMOS (« Complementary Metal-Oxide Semiconductor » en anglais, ou semi-conducteur à oxyde de métal complémentaire) symétrique ou dissymétrique, ou IMOS (« Impact Ionization Metal-Oxide Semiconductor Field-Effect Transistor » en anglais, ou MOSFET à ionisation par impact).

Pour augmenter les performances et la densité d'intégration des transistors dans l'industrie de la microélectronique, les dimensions caractéristiques de ces transistors doivent être réduites à chaque nouvelle génération de transistors. Deux problèmes majeurs s'opposent à cette réduction des dimensions :
- l'augmentation des courants de fuite dans les transistors, augmentant par conséquent leurs consommations électriques,
- l'augmentation des contraintes technologiques, notamment pour maîtriser les dimensions nanométriques des éléments des transistors à réaliser.

Dans ce contexte, l'industrie des semi-conducteurs est amenée à explorer des voies parallèles au CMOS : le TFET et le IMOS sont deux candidats potentiels pour surmonter ces problèmes. Par rapport à un transistor de type MOS possédant des zones de source et de drain du même type de dopage et classiquement symétriques (dopées P+ pour un PMOS et N+ pour un NMOS), un transistor TFET comporte une dissymétrie de dopage entre sa source (P+) et son drain (N+). Un transistor IMOS comporte une double dissymétrie: tout d'abord une dissymétrie de dopage entre sa source (P+) et son drain (N+), mais également une dissymétrie structurelle au niveau de la zone intrinsèque de canal, se trouvant entre la source et le drain, qui n'est pas entièrement recouverte par la grille, du côté de la source du transistor.

Les dispositifs de type TFET ou IMOS permettent d'obtenir un meilleur compromis entre le courant OFF, le courant ON et la tension de seuil, et donc de diminuer la consommation énergétique de ces dispositifs par rapport à un dispositif de type CMOS. Toutefois, comparés à la technologie CMOS, ces deux types de dispositifs sont plus difficiles à réaliser, notamment à cause de la dissymétrie de dopage entre la source et le drain.

Pour réaliser une dissymétrie de dopage entre la source et le drain en technologie planaire, il existe aujourd'hui deux techniques:
- aligner les niveaux d'implantation N et P par rapport au milieu de la grille. Cette méthode nécessite de maîtriser un alignement à plus ou moins L_{G}/2, avec L_{G} longueur de la grille, ce qui la rend difficilement compatible avec les dimensions nanométriques des éléments que l'on cherche à obtenir car, même avec les dernières générations d'outils lithographiques, la limite théorique du désalignement, c'est-à-dire la précision de la machine de lithographie, niveau à niveau obtenue est environ de +/- 40 nm. Une telle technique, mise en oeuvre pour la réalisation d'un transistor de type IMOS, est par exemple décrite dans le document « High Current Drive in Ultra-Short Impact Ionization MOS (I-MOS) Devices » de C. Charbuillet et al., IEDM, San Francisco, 11 décembre 2006.
- utiliser une couche déjà dopée pour réaliser soit la source, soit le drain, que l'on vient protéger par une couche d'oxyde. Il n'y a plus alors qu'une seule implantation à réaliser. Une telle technique est par exemple décrite dans le document « 70-nm Impact-Ionization Metal-Oxide-Semiconductor (IMOS) Devices Integrated with Tunneling Field-Effect Transistors (TFETs) » de W.Y. Choi et al., IEDM 2005, pages 975 à 978. Avec cette technique, le problème de l'alignement par rapport au milieu de la grille ne se pose plus. Cependant, ce procédé n'est pas compatible avec une technologie CMOS car, pour obtenir par exemple un N-IMOS, il est nécessaire d'utiliser au départ du procédé une couche N+ qui formera le drain et un oxyde de protection pour l'implantation P+, et pour obtenir un P-IMOS, il faut utiliser une couche P+ à la place de la couche N+. De plus, l'architecture obtenue n'est plus tout à fait planaire (les contacts source et drain ne sont pas au même niveau).

Pour obtenir des longueurs de grilles nanométriques, il existe actuellement trois solutions : soit mettre en oeuvre un procédé de photolithographie e-beam (par faisceau d'électrons) suivi éventuellement d'une étape de « trimming », ou rognage, soit utiliser un réticule à décalage de phase suivi éventuellement d'une étape de trimming, soit enfin utiliser une étape de photolithographie DUV (en ultra violet profond) comportant une étape de trimming (avec utilisation ou non d'un masque dur). Dans cette dernière solution, utilisant un masque dur, on dépose tout d'abord ce masque sur un empilement de grille (couche de grille et diélectrique de grille) à partir duquel la grille sera réalisée. Une première lithographie DUV suivie d'une étape de gravure permet ensuite de réaliser le masque dur selon certaines dimensions. On réalise ensuite un trimming consistant à réduire les dimensions du masque dur, par une attaque chimique, pour amener la longueur du masque égale à la longueur de la grille souhaitée, cette longueur étant en général une dimension inférieure à la résolution pouvant être obtenue par des outils lithographiques. On vient ensuite graver l'empilement de grille selon le motif défini par le masque dur pour obtenir la grille. Le document US 6 828 259 décrit un tel procédé.

Par ailleurs, la lithographie e-beam a pour inconvénient d'être très longue, et l'utilisation d'un réticule à décalage de phase est très coûteuse notamment à cause de la fabrication du réticule.

Le document US 2005/272259 A1 décrit un procédé de réalisation de grille comportant les étapes de rognage d'un premier masque et de réalisation d'un second masque. Le document US-A-5 918 128 décrit un procédé de réalisation de grille avec deux implantations ioniques pour introduire une dissymétrie de dopage entre la source et le drain du transistor.

### EXPOSÉ DE L'INVENTION

Un but de la présente invention est de proposer un procédé de réalisation de transistor permettant d'une part, d'obtenir des transistors comportant des grilles de dimensions nanométriques en utilisant une lithographie optique peu coûteuse car utilisant ni faisceau d'électrons ni réticule à décalage de phase, et d'autre part d'introduire éventuellement une dissymétrie de dopage entre la source et le drain du transistor, tout en étant compatible avec une technologie CMOS.

Pour cela, il est proposé un procédé de réalisation de grille comme défini dans la revendication 1.

Ainsi, il est possible de réaliser des grilles de dimensions nanométriques sans être limité par la résolution des outils lithographiques. De plus, ce procédé n'empêche pas la réalisation d'une dissymétrie de dopage ou structurelle, par exemple pour la réalisation d'un transistor de type TFET ou IMOS, tout en étant utilisable pour la réalisation de transistors de type CMOS. Ce procédé ne fait pas appel à une lithographie par faisceau d'électrons, ce qui représente un gain de temps très important par rapport aux procédés nécessitant une lithographie par faisceau d'électrons. Enfin, le coût de réalisation du masque utilisé est réduit par rapport aux procédés de l'art antérieur faisant appel à un réticule à décalage de phase.

La réalisation du second masque de gravure peut être obtenue par une étape de dépôt d'une couche de second masque au moins sur la seconde partie de la couche de grille et sur le premier masque de gravure et une étape de polissage mécano-chimique de la couche de second masque, mettant à nu le premier masque de gravure et formant le second masque de gravure.

Ce procédé n'implique pas la mise en oeuvre de traitements thermiques à des températures élevées, par exemple supérieures à environ 600°C. Ce procédé est donc compatible avec certains matériaux ne supportant pas de telles températures élevées, comme par exemple le germanium. Dans ce procédé, les températures les plus élevées sont atteintes lors des étapes de dépôt impliquant des températures inférieures à environ 600°C, ces températures pouvant par exemple atteindre au maximum 450°C.

Le procédé de réalisation d'un transistor de type MOS, comportes les étapes de :
- réalisation d'un empilement comportant au moins un substrat à base d'au moins un semi-conducteur, sur lequel sont disposées une couche diélectrique, une couche de grille et une couche de premier masque,
- mise en oeuvre d'un procédé de réalisation de grille tel que décrit ci-dessus,
- retrait du second masque de gravure,
- implantation ionique dans une partie du substrat non recouverte par la grille, formant les zones de source et de drain du transistor.

L'implantation ionique peut être mise en oeuvre par une première étape de réalisation de régions faiblement dopées par implantation d'ions dans la partie du substrat non recouverte par la grille, de chaque côté de la grille, destinées à être accolées à la zone de canal du transistor, et en une seconde étape de dopage de la partie du substrat non recouverte par la grille, formant les zones de source et de drain du transistor.

On entend par faiblement dopées, ici et dans tout le reste du document, un dopage inférieur au dopage des zones de source et de drain réalisé lors de la seconde étape de dopage. Les régions faiblement dopées sont également appelées régions LDD ou LDS (« Lightly Dopped Drain or Source »).

De plus, le procédé peut comporter, entre la première étape de réalisation de régions faiblement dopées et la seconde étape de dopage, une étape de réalisation d'un ou plusieurs espaceurs au bord de la grille, la seconde étape de dopage étant réalisée dans la partie du substrat non recouverte par la grille et par ledit ou lesdits espaceurs.

Ainsi, il est possible de réaliser un transistor de type MOS dissymétrique. Les avantages d'un tel transistor sont par exemple décrits dans le document « 0.35-µm Asymmetric and Symmetric LDD Device Comparison Using a Reliability/Speed/Power Methodology » de J.F. Chen et al., IEEE Electron Device Letters, vol. 19, n° 7, Juillet 1998.

La présente invention concerne un procédé de réalisation d'un transistor, comportant au moins les étapes de, par exemple dans cet ordre :
a) réalisation d'un empilement comportant au moins un substrat à base d'au moins un semi-conducteur, sur lequel sont disposées une couche diélectrique, une couche de grille et une couche de premier masque ;
b) réalisation d'un premier masque de gravure à partir de la couche de premier masque, un bord du premier masque de gravure formant un motif d'un premier bord d'une grille du transistor à réaliser,
c) gravure d'au moins une première partie de la couche de grille non recouverte par le premier masque de gravure, formant le premier bord de la grille,
d) première implantation ionique dans une première partie du substrat non recouverte par la couche de grille,
e) rognage dudit bord du premier masque de gravure sur une longueur sensiblement égale à une longueur de grille du transistor, révélant une seconde partie de la couche de grille,
f) réalisation d'un second masque de gravure au moins sur la seconde partie de la couche de grille et sur une partie de la couche diélectrique non recouverte par la couche de grille,
g) retrait du premier masque de gravure,
h) gravure d'une troisième partie de la couche de grille non recouverte par le second masque de gravure, formant un second bord de la grille, la partie restante de la couche de grille formant la grille,
i) seconde implantation ionique dans une seconde partie du substrat non recouverte par la grille et/ou par le second masque de gravure,
j) retrait du second masque de gravure.

Ce procédé permet de réaliser un transistor par exemple de type MOS, TFET ou encore IMOS dont la grille est de dimensions nanométriques sans être limité par la résolution des outils lithographiques. Ce procédé présente les mêmes avantages que ceux décrits précédemment concernant le procédé de réalisation de grille et le procédé de réalisation du transistor de type MOS. De plus, ce procédé permet de faire appel à un nombre de masques de gravure limité.

La réalisation du second masque de gravure peut être obtenue par une étape de dépôt d'une couche de second masque au moins sur la seconde partie de la couche de grille, sur la partie de la couche diélectrique non recouverte par la couche de grille et sur le premier masque de gravure, et une étape de polissage mécano-chimique de la couche de second masque, mettant à nu le premier masque de gravure et formant le second masque de gravure.

Là encore, ce procédé n'implique pas la mise en oeuvre de traitements thermiques à des températures élevées et permet donc l'utilisation de certains matériaux ne supportant pas de telles températures élevées.

Le premier et/ou le second masque de gravure peuvent être à base de SiO₂, et/ou de SiN, et/ou de carbone amorphe.

Ainsi, contrairement aux masques de gravure à base de polymères, en utilisant de tels matériaux pour réaliser les masques de gravure, le rognage de l'étape e) peut être réalisé sur une longueur choisie, correspondant à celle de la grille, indépendamment de l'anisotropie des matériaux des masques utilisés. Le facteur de forme de la grille que l'on souhaite réaliser n'est donc pas limité pas l'anisotropie du matériau du masque de gravure utilisé.

Les première et seconde implantations ioniques peuvent former des zones de source et de drain dopées d'un même type de conductivité. Ainsi, le transistor réalisé est de type MOS.

Dans une variante, l'une de la première ou de la seconde implantation ionique peut former une zone dopée de type N+ et l'autre de la première ou de la seconde implantation ionique peut former une zone dopée de type P+. Ainsi, le transistor réalisé est de type TFET ou IMOS. Cette possibilité de réaliser des zones dopées asymétriquement peut notamment être obtenue en réalisant le second masque de gravure entre les deux étapes d'implantation.

La première et/ou la seconde implantation ionique peut être mise en oeuvre par une première étape de réalisation d'au moins une région faiblement dopée LDD (« Lightly Dopped Drain») ou LDS (« Lightly Dopped Source »), par implantation d'ions, respectivement dans ladite première et/ou seconde partie du substrat, destinée à être accolée à la zone de canal du transistor, et en une seconde étape de dopage, formant par exemple au moins une région de type HDD (« Heavy Dopped Drain ») ou HDS (« Heavy Dopped Source »), de ladite première et/ou seconde partie du substrat, formant la zone de source et/ou de drain du transistor.

Dans ce cas, le procédé peut comporter en outre, entre la première étape de réalisation de région faiblement dopée et la seconde étape de dopage, une étape de réalisation d'au moins un espaceur au bord de la grille, la seconde étape de dopage étant réalisée dans la partie du substrat non masquée et/ou non recouverte par l'espaceur.

De plus, le procédé peut comporter en outre, entre l'étape h) et l'étape i), une étape de réalisation d'au moins un espaceur sur la couche diélectrique, accolé au second bord de la grille, la seconde implantation ionique de l'étape i) pouvant être alors réalisée dans la seconde partie du substrat également non recouverte par ledit espaceur. Ainsi, le transistor réalisé est de type IMOS.

L'étape e) de rognage du bord du premier masque de gravure peut être réalisée par une attaque chimique isotrope.

Le procédé peut comporter, après l'étape j) de retrait du second masque de gravure, une étape de retrait de parties de la couche diélectrique non recouvertes par la grille.

Le procédé peut comporter, après l'étape de retrait des parties de la couche diélectrique non recouvertes par la grille, une étape de réalisation d'espaceurs de grille autour de la grille.

Enfin, le procédé peut comporter en outre, après l'étape de retrait des parties de la couche diélectrique non recouvertes par la grille, une étape de réalisation d'une couche de siliciure sur les parties dopées du substrat.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 9 représentent des étapes d'un procédé de réalisation d'un transistor de type TFET, objet de la présente invention,
- les figures 10 à 13 représentent des étapes d'un procédé de réalisation d'un transistor de type IMOS, objet de la présente invention,
- les figures 14 et 15 représentent chacune une vue de dessus d'un dispositif réalisé selon un procédé de réalisation, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

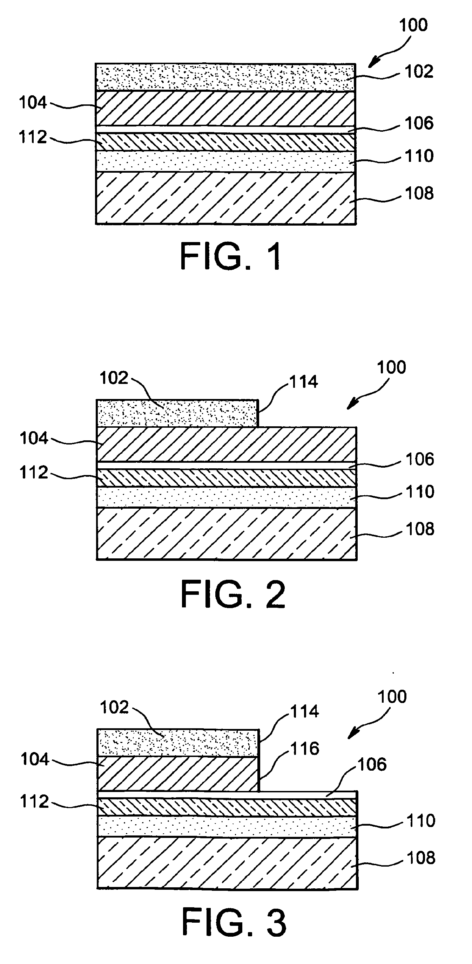

On se réfère tout d'abord aux figures 1 à 9 qui représentent les étapes d'un procédé de réalisation d'un TFET 100 présentant une dissymétrie entre une source P+ et un drain N+.

Sur la figure 1, on réalise tout d'abord un empilement d'une couche de premier masque 102, par exemple à base de SiO₂, et/ou de SiN, et/ou de carbone amorphe, sur une couche de grille 104, par exemple à base d'un matériau métallique et/ou de polysilicium, et/ou de TiN et/ou de tout autre matériau compatible pour former un matériau de grille pouvant être gravé, elle-même disposée sur une couche diélectrique 106, par exemple à base de SiO₂, et/ou de SiON obtenu par exemple par nitruration de SiO₂ et/ou de tout autre diélectrique à forte permittivité (HfO₂ et/ou ZrO₂ et/ou Al₂O₃, ...), destinée à former un diélectrique de grille. La couche diélectrique 106 est disposée sur un substrat SOI (« Silicon On Insulator » en anglais, ou silicium sur isolant) formé par une première couche 108 à base d'au moins un semi-conducteur, par exemple du silicium et/ou du germanium et/ou un alliage à base de SiGe, une couche d'oxyde enterrée 110, par exemple à base de SiO₂, et d'une seconde couche 112 à base d'au moins un semi-conducteur, par exemple du silicium. Cet empilement peut par exemple être réalisé par dépôt CVD (dépôt chimique en phase vapeur) et/ou PECVD (dépôt chimique en phase vapeur assisté par plasma) et/ou LPCVD (dépôt chimique en phase vapeur basse pression) et/ou ALCVD (dépôt chimique en phase vapeur par couche atomique) et/ou MOCVD (dépôt chimique en phase vapeur métallo organique) et/ou SACVD (dépôt chimique en phase vapeur sub-atmosphérique) et/ou par un dépôt par rotation (spin-on).

Sur la figure 2, on réalise une lithographie optique, par exemple de type DUV, et une gravure de la couche de premier masque 102 afin de former un premier masque dur dont un bord droit 114 est destiné à définir un premier côté de la future grille du transistor 100. Dans la suite de la description, la référence 102 est utilisée pour désigner le premier masque dur.

On grave ensuite de manière anisotrope une partie de la couche de grille 104 qui n'est pas recouverte par le premier masque dur 102, en s'arrêtant sur la couche diélectrique 106, définissant ainsi un bord 116 droit de la future grille du transistor 100 (figure 3).

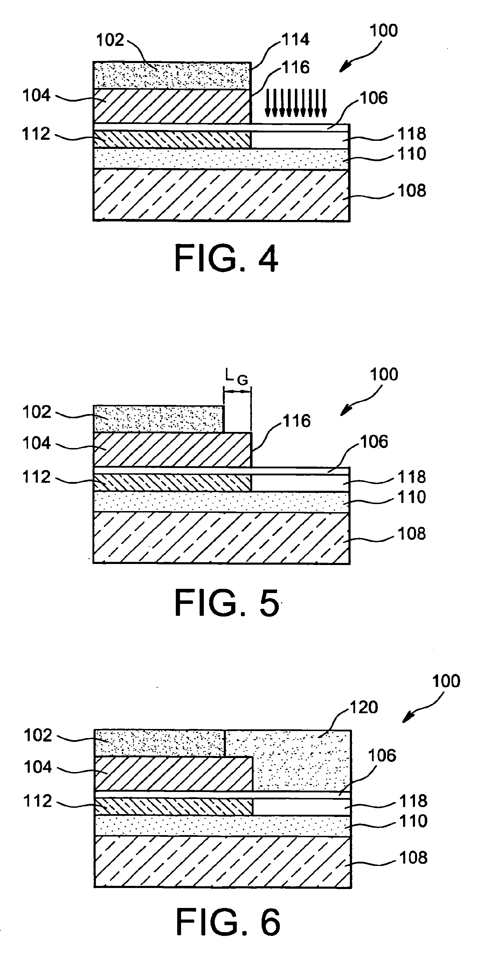

Sur la figure 4, on réalise ensuite une première implantation ionique dans une partie de la seconde couche de silicium 112 non recouverte par la couche de grille 104, formant une zone de drain N+ 118.

Dans une variante, la première implantation ionique peut consister en une première étape de réalisation d'une région faiblement dopée LDD ou LDS, non représentée, par implantation d'ions dans la partie de la seconde couche de silicium 112 non recouverte par la couche de grille 104. Cette région est implantée telle que celle-ci se trouve à côté du bord 116 de la futur grille, destinée à être accolée à la zone de canal du transistor. La première implantation est achevée par une seconde étape de dopage du reste de la partie de la seconde couche de silicium 112 non recouverte par la couche de grille 104, formant la zone de drain N+ 118.

Il est également possible de réaliser, avant de mettre en oeuvre la seconde étape de dopage, un espaceur accolé au bord 116 de la couche de grille 104. Ainsi, lors de la seconde étape de dopage, la région LDD ou LDS implantée près de la future zone de canal est protégée de ce dopage par l'espaceur. Après la seconde étape de dopage, cet espaceur peut être supprimé ou conservé sur le dispositif 100.

Les régions LDD ou LDS sont dopées plus faiblement que les régions de source et de drain. Les doses de dopants implantés dans ces deux types de région peuvent par exemple être comprises entre environ 1.10¹⁴ et 5.10¹⁵ atomes/cm². L'énergie des faisceaux utilisés peut par exemple être comprise entre environ 1 KeV et 100 KeV.

On réalise alors un trimming, ou rognage, du premier masque dur 102, à partir du bord 114, par attaque chimique isotrope, par exemple de type HF à 1% pour un masque dur 102 à base de SiO₂, sur une longueur égale à la longueur de grille L_{G} souhaitée (figure 5). La partie de la couche 104 ainsi découverte est destinée à former la future grille du transistor 100.

Sur la figure 6, on dépose une couche de second masque, par exemple à base de SiO₂ et par LPCVD, sur les parties de la couche diélectrique 106 et de la couche de grille 104 découvertes. Une planarisation par CMP (« Chemical and Mechanical Polishing » en anglais, ou polissage mécano-chimique) permet de supprimer le matériau de cette couche de second masque déposé sur le premier masque dur 102, en s'arrêtant sur le premier masque dur 102, et formant ainsi un second masque dur 120.

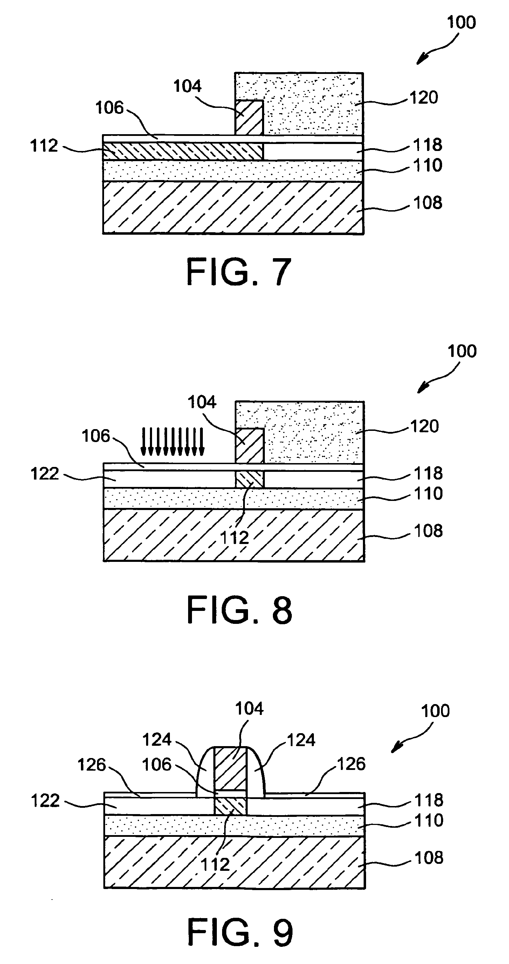

On retire ensuite le premier masque dur 102 de manière sélective par rapport au second masque dur 120, par exemple par attaque chimique de type H₃PO₄ si le premier masque dur 102 est à base de nitrure de silicium et le second masque dur 120 à base de SiO₂. La partie de la couche de grille 104 non recouverte par le second masque dur 120 est ensuite gravée, la partie restante de la couche de grille 104 formant la grille du transistor 100 (figure 7). Dans la suite de la description, la référence 104 est utilisée pour désigner la grille.

Comme représenté sur la figure 8, on réalise alors une seconde implantation ionique dans la seconde couche de silicium 112, formant une source 122, ici P+ pour dissymétriser les dopages de la source et du drain du transistor TFET 100. La partie restante de la seconde couche de silicium 112 forme le canal du transistor 100.

Dans une variante, comme pour la première implantation ionique, la seconde implantation ionique peut consister en une première étape de réalisation d'une région faiblement dopée LDD ou LDS, non représentée, par implantation d'ions dans la partie de la seconde couche de silicium 112 non recouverte par la couche de grille 104 et le second masque de gravure 120. Cette région LDD ou LDS est implantée telle que celle-ci se trouve à côté du bord de la grille 104, destinée à être accolée à la zone de canal du transistor. La seconde implantation est achevée par une seconde étape de dopage du reste de la partie de la seconde couche de silicium 112 non recouverte par la grille 104 et le second masque de gravure 120.

Il est également possible de réaliser, avant de mettre en oeuvre la seconde étape de dopage, un espaceur accolé au bord de la grille 104. Ainsi, lors de la seconde étape de dopage, la région LDD ou LDS implantée près de la future zone de canal est protégée de ce dopage par l'espaceur. Après la seconde étape de dopage, cet espaceur peut être supprimé ou conservé sur le dispositif 100.

Dans le cas d'une réalisation d'un transistor de type MOS, la seconde implantation ionique pourrait former une source symétrique au drain, par exemple de type P+ dans le cas d'une réalisation d'un P-MOS. De plus, il est également possible, dans le cas d'une réalisation d'un transistor de type MOS, de réaliser le dopage des zones de source et de drain par une seule étape d'implantation ionique, par exemple mise en oeuvre après avoir réalisé la grille et supprimé les masques de gravure se trouvant sur ces zones.

De manière générale, dans le cas d'un MOSFET, les implantations réalisées de part et d'autre de la grille sont du même type, mais peuvent avoir, si l'optimisation du transistor le nécessite, des caractéristiques différentes (dose, énergie, angle, dopant).

Ce procédé peut également s'appliquer à la réalisation d'un transistor MOS dissymétrique, au moins un espaceur formé durant au moins une des implantations ioniques permettant de réaliser l'une des zones de source ou de drain différente de l'autre.

Enfin, sur la figure 9, on retire le second masque dur 120, par exemple par gravure, on grave les parties de la couche diélectrique 106 non recouvertes par la grille 104, on réalise des espaceurs 124 autour de la grille 104, et on réalise une couche de siliciure 126 sur la source 122 et le drain 118 du transistor 100 par une succession d'un dépôt d'une couche de métal, par exemple du nickel et/ou du cobalt et/ou du platine, d'un recuit pour former le siliciure, d'un retrait du métal qui n'a pas formé de siliciure, par exemple avec une solution à base de H₂SO₄ et de H₂O₂, puis un recuit dont les paramètres sont déterminés de façon à amener le siliciure à une résistivité la plus faible possible sans dégradation de la couche.

Si des espaceurs ont précédemment été réalisés et conservés sur le dispositif 100 (lors des implantations ioniques), ces espaceurs peuvent alors former les espaceurs 124 autour de la grille 104.

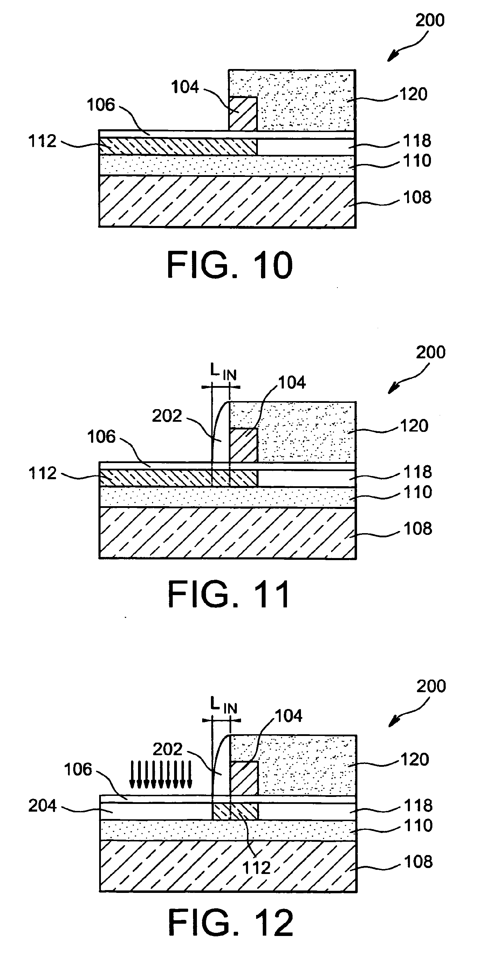

Un procédé de réalisation d'un transistor de type N-IMOS 200 va maintenant être décrit en liaison avec les figures 10 à 13.

Comme représenté sur la figure 10, on réalise tout d'abord des étapes similaires à celles décrites précédemment en liaison avec les figures 1 à 7, par exemple à partir d'une structure similaire à celle représentée sur la figure 1.

On réalise ensuite un espaceur 202, par exemple à base de SiO₂, et/ou de SiN, accolé au bord découvert de la grille 104, de longueur L_{IN} (figure 11).

Sur la figure 12, on réalise ensuite une seconde implantation ionique dans la seconde couche de silicium 112, formant une source 204, ici P+, pour dissymétriser le dopage de la source et du drain du transistor IMOS 200. La partie restante de la seconde couche de silicium 112 forme le canal du transistor 200. De plus, l'espaceur 202 réalisé précédemment joue également le rôle de masque pour cette implantation, les ions n'étant pas implantés dans la partie de la couche 112 se trouvant sous l'espaceur 202.

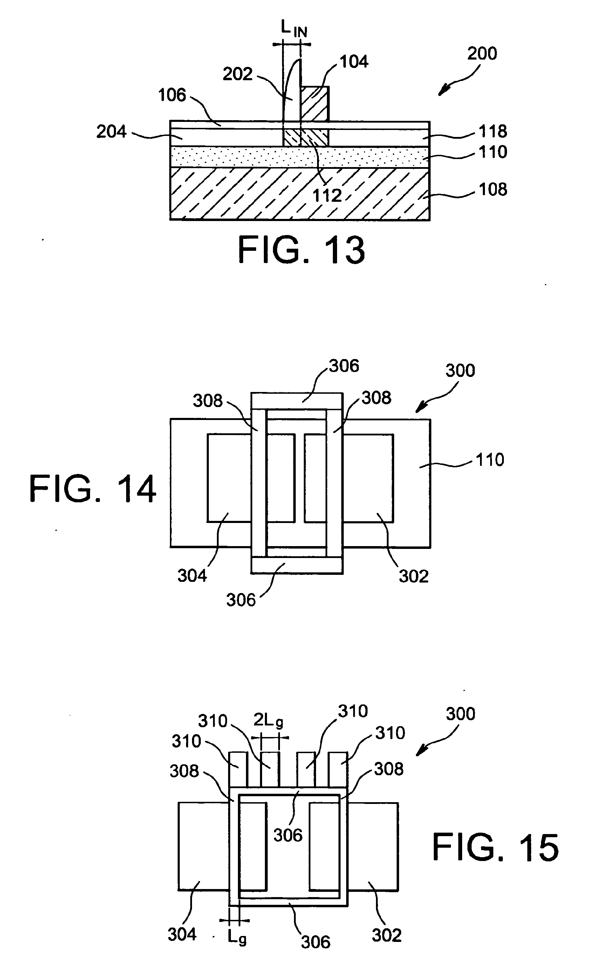

Comme représenté sur la figure 13, on retire le second masque dur 120, par exemple par gravure. Dans le cas où l'espaceur 202 est à base de SiN, celui-ci peut rester présent sur le dispositif 200, contrairement au cas où l'espaceur 202 est à base de SiO₂ qui peut être retiré du dispositif 200 en même temps que le second masque dur 120.

Le dispositif 200 est ensuite achevé de manière similaire au dispositif 100 en réalisant un ou plusieurs espaceurs autour de la grille 104, et en réalisant une couche de siliciure sur la source 204 et le drain 118 du transistor 200. Lorsque l'espaceur 202 est retiré du dispositif 200 en même temps que le second masque dur 120, on réalise, avant la réalisation de la couche de siliciure, une couche de protection de la zone intrinsèque de la couche 112 se trouvant au niveau de la zone précédemment occupée par l'espaceur 202. Cette couche de protection peut être réalisée à base d'un matériau isolant ne réagissant pas avec le métal utilisé pour la siliciuration, par exemple du nitrure de silicium et/ou de l'oxyde de silicium.

On obtient ainsi un transistor N-IMOS 200 comportant une dissymétrie au niveau du dopage de la source (P+) 204 et du drain (N+) 118, et une dissymétrie structurelle au niveau de la zone de canal 112 qui n'est pas entièrement recouverte par la grille 104.

Ce procédé peut également être mis en oeuvre pour la réalisation d'un transistor MOS dissymétrique. Dans ce cas, les deux implantations ioniques forment des zones du même type de conductivité.

Dans les deux procédés décrits précédemment, les transistors 100 et 200 sont réalisés sur un substrat SOI formé par la première couche 108 à base de semi-conducteur, la couche d'oxyde 110 et de la seconde couche 112 à base de semi-conducteur. Dans une variante, ces transistors 100 et 200 pourraient être réalisés sur un substrat massif à base d'au moins un semi-conducteur tel que du silicium, et/ou du germanium et/ou tout autre semi-conducteur. Dans une autre variante, les transistors 100 et 200 pourraient être réalisés sur un substrat GeOI (germanium sur isolant), la seconde couche 112 étant alors à base de germanium, SiGeOI (SiGe sur isolant), ou SSOI (silicium contraint sur isolant).

De même, dans une autre variante des deux procédés décrits précédemment, la couche de premier masque 102 peut être à base de n'importe quel(s) matériau(x) pouvant servir de masque dur durant une étape d'implantation, pouvant être attaquable chimiquement pour la réalisation du rognage de cette couche 102, pouvant servir de couche d'arrêt durant l'étape de planarisation CMP, et pouvant être attaquable de façon sélective vis-à-vis du second masque dur 120. De préférence, cette couche de premier masque 102 est à base de nitrure. Le second masque dur 120 peut également être à base d'au moins un matériau pouvant servir de masque dur durant une étape d'implantation et pouvant être attaquable de façon sélective vis-à-vis de la couche de premier masque 102. De préférence, le second masque dur 120 est à base de SiO₂.

La figure 14 représente une vue de dessus de deux zones actives 302 et 304 de deux transistors d'un dispositif 300 réalisé selon l'un des procédés décrits précédemment. On entend par zone active d'un transistor les zones de source, drain et canal de ce transistor. Ce dispositif 300 est réalisé à partir d'un substrat SOI, la couche d'oxyde enterrée 110 se trouvant sous les zones actives 302 et 304 étant représentée sur cette figure. Sur la figure 14, on voit que la mise en oeuvre des procédés de réalisation des transistors laisse subsister un cordon de grille 306 autour des zones actives 302 et 304. Celui-ci peut être utilisé pour relier les deux grilles 308 des deux transistors. Ce cordon de grille 306 peut avantageusement être utilisé lors de la réalisation d'un inverseur à partir des deux transistors du dispositif 300, par exemple deux transistors de type TFET similaires au transistor 100, dont les grilles sont reliées. Il est également possible de ne définir qu'une seule zone active dans le cas de la réalisation d'un inverseur. Enfin, si l'on veut supprimer ce cordon de grille 306 après la réalisation des transistors, on réalise une étape de masquage des grilles des transistors et une étape de gravure supplémentaire.

Les grilles des transistors réalisés par l'un des procédés décrits précédemment sont ensuite connectées à un contact de grille. Si la longueur de grille L_{G} est inférieure à la taille du contact de grille, on peut définir des zones reliées aux grilles, se trouvant en dehors des zones actives des transistors, de dimensions supérieures à celles des grilles et permettant d'y connecter un ou plusieurs contacts de grille. Par exemple, sur la figure 15, représentant le dispositif 300, on voit que les grilles 308 sont reliées par le cordon de grille 306 et que des zones 310 réalisées à partir de la couche de grille avec laquelle sont réalisées les grilles 308, forment des doigts de dimension comprise entre environ L_{G} et 2 L_{G}. Un contact de grille peut alors être réalisé, relié à plusieurs zones 310.

Avec les procédés décrits précédemment, il est possible de réaliser des circuits comportant des transistors de type MOS et/ou de type IMOS et/ou de type TFET, permettant ainsi d'exploiter sur un même dispositif les spécificités de chacun et d'optimiser les performances du circuit.

## Revendications

1. Procédé de réalisation d'un transistor (100, 200), comportant au moins les étapes de :
a) réalisation d'un empilement comportant au moins un substrat (112) à base d'au moins un semiconducteur, sur lequel sont disposées une couche diélectrique (106), une couche de grille (104) et une couche de premier masque (102),
b) réalisation d'un premier masque de gravure à partir de la couche de premier masque (102), un bord (114) du premier masque de gravure formant un motif d'un premier bord (116) d'une grille du transistor (100, 200) à réaliser,
c) gravure d'au moins une première partie de la couche de grille (104) non recouverte par le premier masque de gravure, formant le premier bord (116) de la grille,
d) première implantation ionique dans une première partie du substrat (112) non recouverte par la couche de grille (104),
e) rognage dudit bord (114) du premier masque de gravure sur une longueur sensiblement égale à une longueur de grille du transistor (100, 200), révélant une seconde partie de la couche de grille (104),
f) réalisation d'un second masque de gravure (120) au moins sur la seconde partie de la couche de grille (104) et sur une partie de la couche diélectrique (106) non recouverte par la couche de grille (104),
g) retrait du premier masque de gravure,
h) gravure d'une troisième partie de la couche de grille (104) non recouverte par le second masque de gravure (120), formant un second bord de la grille, la partie restante de la couche de grille (104) formant la grille,
i) seconde implantation ionique dans une seconde partie du substrat (112) non recouverte par la grille et/ou par le second masque de gravure (120),
j) retrait du second masque de gravure (120).

2. Procédé selon la revendication 1, la couche diélectrique (106) étant à base de SiO₂ et/ou de tout autre matériau diélectrique à forte permittivité, tel que du HfO₂, et/ou du ZrO₂, et/ou du Al₂O₃.

3. Procédé selon l'une des revendications précédentes, la réalisation du second masque de gravure (120) étant obtenue par une étape de dépôt d'une couche de second masque au moins sur la seconde partie de la couche de grille (104), sur la partie de la couche diélectrique (106) non recouverte par la couche de grille (104) et sur le premier masque de gravure (102), et une étape de polissage mécano-chimique de la couche de second masque, mettant à nu le premier masque de gravure (102) et formant le second masque de gravure (120).

4. Procédé selon l'une des revendications précédentes, les première et seconde implantations ioniques formant des zones de source et de drain dopées d'un même type de conductivité.

5. Procédé selon l'une des revendications 1 à 3, l'une de la première ou de la seconde implantation ionique formant une zone dopée de type N+ (118) et l'autre de la première ou de la seconde implantation ionique formant une zone dopée de type P+ (122).

6. Procédé selon l'une des revendications 1 à 4, la première et/ou la seconde implantation ionique étant mise en oeuvre par une première étape de réalisation d'au moins une région faiblement dopée par implantation d'ions, respectivement dans ladite première et/ou seconde partie du substrat (112), destinée à être accolée à la zone de canal du transistor, et en une seconde étape de dopage de ladite première et/ou seconde partie du substrat (112).

7. Procédé selon la revendication 6, comportant en outre, entre la première étape de realisation de région faiblement dopée et la seconde étape de dopage, une étape de réalisation d'au moins un espaceur au bord de la grille, la seconde étape de dopage étant réalisée dans la partie du substrat (112) non masquée et/ou non recouverte par l'espaceur.

8. Procédé selon l'une des revendications 1 à 5, comportant en outre, entre l'étape h) et l'étape i), une étape de réalisation d'au moins un espaceur (202) sur la couche diélectrique (106), accolé au second bord de la grille, la seconde implantation ionique de l'étape i) étant réalisée dans la seconde partie du substrat (112) également non recouverte par ledit espaceur (202).

9. Procédé selon l'une des revendications précédentes, l'étape e) de rognage du bord (114) du premier masque de gravure étant réalisée par une attaque chimique isotrope.

10. Procédé selon l'une des revendications précédentes, comportant en outre, après l'étape j) de retrait du second masque de gravure (120), une étape de retrait de parties de la couche diélectrique (106) non recouvertes par la grille.

11. Procédé selon la revendication 10, comportant en outre, après l'étape de retrait des parties de la couche diélectrique (106) non recouvertes par la grille, une étape de réalisation d'espaceurs de grille (124) autour de la grille.

12. Procédé selon l'une des revendications 10 ou 11, comportant en outre, après l'étape de retrait des parties de la couche diélectrique (106) non recouvertes par la grille (124), une étape de réalisation d'une couche de siliciure (126) sur les parties dopées du substrat (112).

13. Procédé selon l'une des revendications précédentes, la couche de grille (104) étant à base d'au moins un matériau métallique et/ou de polysilicium, et/ou de TiN et/ou de tout autre matériau compatible pour former un matériau de grille de transistor.

14. Procédé selon l'une des revendications précédentes, le premier et/ou le second (120) masque de gravure étant à base de SiO₂, et/ou de SiN, et/ou de carbone amorphe.

## Claims

1. Method of producing a transistor (100, 200), comprising at least the steps of:
a) producing a stack comprising at least one substrate (112) comprising at least on semiconductor, on which there are disposed a dielectric layer (106), a gate layer (104) and a layer of first mask (102),
b) producing a first etching mask from the layer of first mask (102), one edge (114) of the first etching mask forming a pattern of a first edge (116) of a gate of the transistor (100, 200) to be produced,
c) etching at least a first part of the gate layer (104) not covered by the first etching mask, forming the first edge (116) of the gate,
d) first ion implantation in a first part of the substrate (112) not covered by the gate layer (104),
e) trimming said edge (114) of the first etching mask over a length substantially equal to a gate length of the transistor (100, 200), revealing a second part of the gate layer (104),
f) producing a second etching mask (120) at least on the second part of the gate layer (104) and on a part of the dielectric layer (106) not covered by the gate layer (104),
g) removing the first etching mask,
h) etching a third part of the gate layer (104) not covered by the second etching mask (120), forming a second edge of the gate, the remaining part of the gate layer (104) forming the gate,
i) second ion implantation in a second part of the substrate (112) not covered by the gate and/or by the second etching mask (120),
j) removal of the second etching mask (120).

2. Method according to claim 1, the dielectric layer (106) comprising SiO₂ and/or on any other dielectric material with high permittivity, such as HfO₂ and/or ZrO₂ and/or Al₂O₃.

3. Method according to any one of previous claims, the production of the second etching mask (120) being obtained by a step of deposition of a layer of second mask at least on the second part of the gate layer (104), on the part of the dielectric layer (106) not covered by the gate layer (104) and on the first etching mask (102), and a step of chemical-mechanical planarization of the layer of second mask, baring the first etching mask (102) and forming the second etching mask (120).

4. Method according to any one of previous claims, the first and second ion implantations forming source and drain regions doped with the same type of conductivity.

5. Method according to any one of claims 1 to 3, one of the first or second ion implantations forming a doped region of the N+ type (118) and the other one of the first or the second ion implantations forming a doped region of the P+ type (122).

6. Method according to any one of claims 1 to 4, the first and/or second ion implantation being implemented by a first step of producing at least one lightly doped region by ion implantation, respectively in said first and/or second part of the substrate (112), intended to be up against the channel region of the transistor, and a second step of doping said first and/or second part of the substrate (112).

7. Method according to claim 6, also comprising, between the first step of producing a lightly doped region and the second doping step, a step of producing at least one spacer at the edge of the gate, the second doping step being performed in the part of the substrate (112) not masked and/or not covered by the spacer.

8. Method according to any one of claims 1 to 5, also comprising, between step h) and step i), a step of producing at least one spacer (202) on the dielectric layer (106), up against the second edge of the gate, the second ion implantation of step i) being performed in the second part of the substrate (112) also not covered by said spacer (202).

9. Method according to any one of preceding claims, step e) of trimming the edge (114) of the first etching mask being performed by an isotropic chemical attack.

10. Method according to any one of previous claims, also comprising, after step j) of removing the second etching mask (120), a step of removing parts of the dielectric layer (106) not covered by the gate.

11. Method according to claim 10, also comprising, after the step of removing the parts of the dielectric layer (106) not covered by the gate, a step of producing gate spacers (124) around the gate.

12. Method according to any one of claims 10 or 11, also comprising, after the step of removing the parts of the dielectric layer (106) not covered by the gate (124), a step of producing a layer of silicide (126) on the doped parts of the substrate (112).

13. Method according to any one of preceding claims, the gate layer (104) comprising at least one metal and/or polysilicon material, and/or TiN and/or any other compatible material for forming a transistor gate material.

14. Method according to any one of preceding claims, the first and/or the second (120) etching mask comprising SiO₂ and/or SiN and/or amorphous carbon.

## Patentansprüche

1. Verfahren zur Herstellung eines Transistors (100, 200), wenigstens die folgenden Schritte umfassend:
a) Realisierung eines Stapels mit wenigstens einem Substrat (112) auf der Basis wenigstens eines Halbleiters, auf dem eine dielektrische Schicht (106), eine Gateschicht (104) und eine erste Maskenschicht (102) angeordnet sind,
b) Realisierung einer ersten Ätzmaske aus der ersten Maskenschicht (102), wobei ein Rand (114) der ersten Ätzmaske ein Muster eines ersten Rands (116) eines Gates des zu realisierenden Transistors (100, 200) bildet,
c) Ätzen wenigstens eines ersten Teils des nicht von der ersten Ätzmaske bedeckten Teils der Gateschicht (104), um den ersten Rand (116) des Gates auszubilden,
d) erste Ionenimplantation in einem ersten, nicht von der Gateschicht (104) bedeckten Teil des Substrats (112),
e) Abätzen des genannten Rands (114) der ersten Ätzmaske über eine Länge im Wesentlichen gleich der Länge des Gates des Transistors (100, 200), um einen zweiten Teil der Gateschicht (104) freizulegen,
f) Realisierung einer zweiten Ätzmaske (120) wenigstens in dem zweiten Teil der Gateschicht (104) und in einem nicht von der Gateschicht (104) bedeckten Teil der dielektrischen Schicht (106),
g) Entfernen der ersten Ätzmaske,
h) Ätzen eines nicht durch die zweite Ätzmaske (120) bedeckten dritten Teils der Gateschicht (104), um einen zweiten Rand des Gates auszubilden, wobei dann der verbleibende Teil der Gateschicht (104) das Gate bildet,
i) zweite Ionenimplantation in einem nicht von dem Gate und/oder der zweiten Ätzmaske (120) bedeckten zweiten Teil des Substrats (112),
j) Entfernen der zweiten Ätzmaske (120).

2. Verfahren nach Anspruch 1, wobei die dielektrische Schicht (106) auf SiO₂ und/oder jedem anderen dielektrischen Material mit hoher Permitivität basiert, etwa HfO₂ und/oder ZrO₂ und/oder Al₂O₃.

3. Verfahren nach einem der vorhergehenden Ansprüche, wobei man die zweite Ätzmaske (120) realisiert durch einen Schritt zur Abscheidung der Schicht der zweiten Maske auf wenigstens dem zweiten Teil der Gateschicht (104), dem nicht durch die Gateschicht (104) bedeckten Teil der dielektrischen Schicht (106) und der ersten Ätzmaske (102), und einen Schritt zur mechano-chemischen Politur der Schicht der zweiten Maske, wobei die erste Ätzmaske (102) bloßgelegt und die zweite Ätzmaske (120) gebildet wird.

4. Verfahren nach einem der vorhergehenden Ansprüche, wobei die erste und die zweite Ionenimplantation Source- und Drain-Zonen bilden, die mit demselben Leitfähigkeitstyp dotiert sind.

5. Verfahren nach einem der Ansprüche 1 bis 3, wobei eine der Ionenimplantationen, die erste oder die zweite, eine N+-dotierte Zone (118) bildet, und die jeweils andere eine P+-dotierte Zone (122) bildet.

6. Verfahren nach einem der Ansprüche 1 bis 4, wobei die erste und/oder zweite Ionenimplantation realisiert wird durch einen ersten Schritt zur Herstellung - jeweils in dem genannten ersten und/oder zweiten Teil des Substrats (112) - wenigstens eines schwach durch Ionenimplantation dotierten Bereichs, dazu bestimmt, mit der Kanalzone des Transistors verbunden zu sein, und durch einen zweiten Schritt zur Dotierung des genannten ersten und/oder zweiten Teils des Substrats (112).

7. Verfahren nach Anspruch 6, mit außerdem - zwischen dem ersten Schritt zur Herstellung eines schwach dotierten Bereichs und dem die Dotierung umfassenden zweiten Schritt - einem Schritt zur Herstellung wenigstens eines Spacers am Rande des Gates, wobei der die Dotierung umfassende zweite Schritt in dem nicht maskierten und/oder nicht von dem Spacer bedeckten Teil des Substrats (112) realisiert wird.

8. Verfahren nach einem der Ansprüche 1 bis 5, mit außerdem zwischen dem Schritt h) und dem Schritt i) einem Schritt zur Herstellung wenigstens eines Spacers (202) auf der dielektrischen Schicht (106), angefügt an den zweiten Rand des Gates, wobei die zweite Ionenimplantation des Schritt i) in dem ebenfalls nicht von dem genannten Spacer (202) bedeckten zweiten Teil des Substrats (112) realisiert wird.

9. Verfahren nach einem der vorhergehenden Ansprüche, wobei in Schritt e) das Abätzen des Rands (114) der ersten Ätzmaske durch isotropes chemisches Ätzen realisiert wird.

10. Verfahren nach einem der vorhergehenden Ansprüche, außerdem umfassend, nach dem Schritt j) zum Entfernen der zweiten Ätzmaske (120), einen Schritt zum Entfernen von nicht durch das Gate bedeckten Teilen der dielektrischen Schicht (106).

11. Verfahren nach Anspruch 10, außerdem umfassend, nach dem Schritt zum Entfernen der nicht durch das Gate bedeckten Teile der dielektrischen Schicht (106), einen Schritt zur Herstellung von Gate-Spacern (124) um das Gate herum.

12. Verfahren nach einem der Ansprüche 10 oder 11, außerdem umfassend, nach dem Schritt zum Entfernen der nicht durch das Gate bedeckten Teile der dielektrischen Schicht (106), einen Schritt zur Realisierung einer Silicidschicht (126) auf den dotierten Teilen des Substrats (112).

13. Verfahren nach einem der vorhergehenden Ansprüche, wobei die Gateschicht (104) auf wenigstens einem metallischen Material und/oder Polysilizium und/oder TiN und/oder jedem anderen mit der Bildung eines Transistor-Gates kompatiblen Material basiert.

14. Verfahren nach einem der vorhergehenden Ansprüche, wobei die erste und/oder die zweite (120) Ätzmaske auf SiO₂ und/oder SiN und/oder amorphem Kohlenstoff basiert.
